# EUROPÄISCHE PATENTSCHRIFT

(11) **EP 0 622 984 B1**
(45) Veröffentlichungstag und Bekanntmachung des Hinweises auf die Patenterteilung: **15.01.1997**
(21) Anmeldenummer: 94106752.2
(22) Anmeldetag: 29.04.1994
(51) Int. Cl.: H05K 7/20

(54) **Einrichtung zur Wärmeabfuhr von einer schwingungsgedämpft aufgehängten Baugruppe**
Device for heat dissipation for vibration damped suspended electronic assembly
Dispositif pour la dissipation de chaleur d'un ensemble électrique suspendu amorti en vibration

(30) Priorität: 30.04.1993 DE 4314199
(43) Veröffentlichungstag der Anmeldung: 02.11.1994
(73) Patentinhaber: Bodenseewerk Gerätetechnik GmbH, 88662 Überlingen (DE)
(72) Erfinder: Neumann, Werner, D-88696 Owingen (DE)
(74) Vertreter: Weisse, Jürgen, Dipl.-Phys. Patentanwalt

(56) Entgegenhaltungen:
- DE-A- 3 204 273
- GB-A- 2 146 423
- US-A- 2 879 041

## Beschreibung

Die Erfindung betrifft eine Einrichtung zur Wärmeabfuhr von einer schwingungsgedämpft aufgehängten Baugruppe.

Zur Schwingungsdämpfung werden Baugruppen über Gummikörper gelagert. Solche Gummikörper gestatten eine federnde Aufhängung der Baugruppe. Die Gummikörper haben aber auch eine hohe Eigendämpfung, so daß sie Schwingungsenergie absorbieren.

In vielen Fällen entwickeln solche Baugruppen aber auch Wärme, insbesondere in Form von Verlustleistung elektrischer oder elektronischer Bauteile. Diese Wärme muß abgeführt werden. Anderenfalls kann eine Überhitzung der Baugruppe eintreten. Eine solche Überhitzung kann zu Fehlfunktionen oder zur Zerstörung von Bauteilen führen. Wenn aber die Baugruppe über schwingungsdämpfende Gummikörper gelagert ist, dann wird die Wärmeabfuhr durch die schlecht wärmeleitenden Gummikörper behindert.

Aus der DE 32 04 273.1 ist ein Kontaktelement zur Zwischenlage zwischen wärmeleitende Teile eines Gerätes, insbesondere eines Gehäuses für eine elektrische Baugruppe bekannt. Dieses Kontaktelement besteht aus einem streifenförmigen elastischen Träger, auf dem eine gut wärmeleitende Schicht angeordnet ist. Dieses elastische Kontaktelement, das an einem der Bauteile formschlüssig befestigt ist und gegen das andere Bauteil infolge seiner Elastizität reibungsschlüssig anliegt, soll sowohl die Aufgabe der Schwingungsdämpfung zwischen den Bauteilen als auch die Aufgabe der Wärmeübertragung zwischen den Bauteilen übernehmen. Diese Aufgaben kann das Bauteil, das auch wendelförmig ausgebildet sein kann, nur unvollkommen übernehmen. Um eine ausreichende Elastizität zu erreichen, kann die wärmeleitende Schicht nur einen geringen Querschnitt aufweisen, sodass der Wärmeübergang begrenzt ist. Während längerer Betriebsdauer wird der Wärmeübergang von demjenigen Bauteil, gegen das es mit Reibungsschluss anliegt, durch Abnutzung und Korrosion der wärmeleitenden Schicht verschlechtert.

Der Erfindung liegt die Aufgabe zugrunde, eine verbesserte Einrichtung zur Wärmeabfuhr von einer solchen schwingungsgedämpft aufgehängten Baugruppe zu schaffen.

Der Erfindung liegt insbesondere die Aufgabe zugrunde, die Wärme von der schwingungsgedämpft aufgehängten Baugruppe so abzuführen, daß die Schwingungsdämpfung dadurch nicht beeinträchtigt wird.

Erfindungsgemäß wird diese Aufgabe gelöst durch eine Einrichtung zur Wärmeabfuhr von einer schwingungsgedämpft aufgehängten Baugruppe zu einem weiteren Bauteil enthaltend,
(a) wenigstens ein gewendeltes Band, das zumindest teilweise aus einem gut wärmeleitenden Material besteht,
(b) das zwischen einer Mantelfläche der Baugruppe und einer Innenfläche eines die Baugruppe umgebenden Gehäuses die Flächen berührend angeordnet ist und
(c) mit einer der Flächen formschlüssig verbunden ist
   wobei
(d) das gewendelte Band aus einer bandförmig geflochtenen Litze aus gut wärmeleitendem Material besteht und
(e) das gewendelte Band einerseits an mindestens zwei axial gegeneinander versetzten Stellen mit einer Mantelfläche der Baugruppe und andererseits an mindestens zwei axial gegeneinander versetzten Stellen mit einer Innenfläche des Gehäuses formschlüssig wärmeableitend verbunden ist.

Die Verwendung von bandförmig geflochtenen Litzen zur Wärmeableitung ist an sich bekannt. (DE-AS 18 10 675, DE-32 12 592 A1, DE-33 30 708 A1). Beim Gegenstand der Erfindung kommt jedoch der Verwendung von bandförmig geflochtenen Litzen eine besondere Bedeutung zu, da sie infolge ihrer hohen Flexibilität Schwingungen der Baugruppe im Gehäuse in keiner Weise behindern oder beeinflussen, so dass die dort vorhandene schwingungsgedämpfte Aufhängung voll wirksam werden kann. Die formschlüssige Verbindung des gewendelten Bandes, sowohl an Mantelflächen der Baugruppe wie auch an Innenflächen des Gehäuses, stellt einen einwandfreien Wärmeübergang auch während länger Gebrauchsdauer sicher.

Bei einer bevorzugten Ausführungsform sind die Stellen, an denen das Band mit der Baugruppe verbunden ist, axial versetzt gegen die Stellen, an denen das Band mit dem Gehäuse verbunden ist. Hierdurch wird eine sehr gute Bewegungsfreiheit der Baugruppe im Gehäuse erreicht und unerwünscht starke mechanische Beanspruchungen des Bandes werden vermieden.

Weiterhin kann die Baugruppe im Gehäuse über vom Band unabhängige Gummikörper schwingungsgedämpft gelagert sein. Die Verwendung der vom wärmeleitenden Band unabhängigen Gummikörper, wobei es sich auch um Körper aus anderen elastischen Materialien handeln kann erlaubt es, deren Eigenschaften sehr genau auf die gewünschte Schwingungsdämpfung abzustimmen. Die Verwendung von Gummikörpern zur Schwingungsdämpfung ist an sich bekannt ( DE AS 12 09 624). Dort handelt es sich um ein kastenförmig aufgebautet Gerät für die elektrische Nachrichtenübertragungs- und Messtechnik, bei dem die Wärmeableitung durch Kühlluft erfolgt, so dass Schwierigkeiten mit wärmeübertragenden Materialien nicht auftreten können.

Zur Verbesserung der Wärmeableitung kann es zweckmässig sein, um die Baugruppe herum mehrere gewendelte wärmeabführende Bänder anzuordnen und im Bereich der Bänder Kühlkanäle zu bilden.

Ein Ausführungsbeispiel der Erfindung ist nachstehend unter Bezugnahme auf die zugehörigen Zeichnungen näher erläutert.
- Fig.1: zeigt eine Seitenansicht, teilweise im Schnitt einer in einem Gehäuse schwingungsgedämpft aufgehängten Baugruppe mit wendelförmigen Bändern zur Wärmeabfuhr.

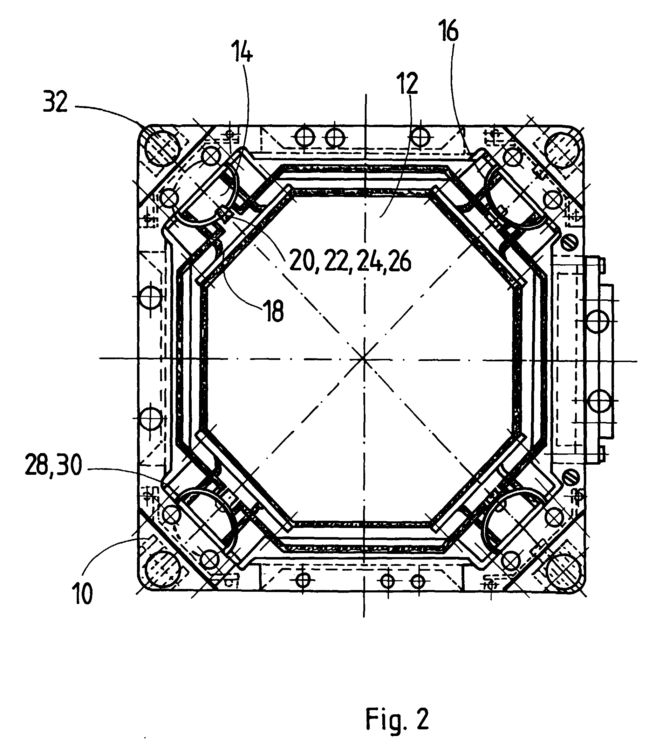

- Fig.2: zeigt eine zugehörige Draufsicht.

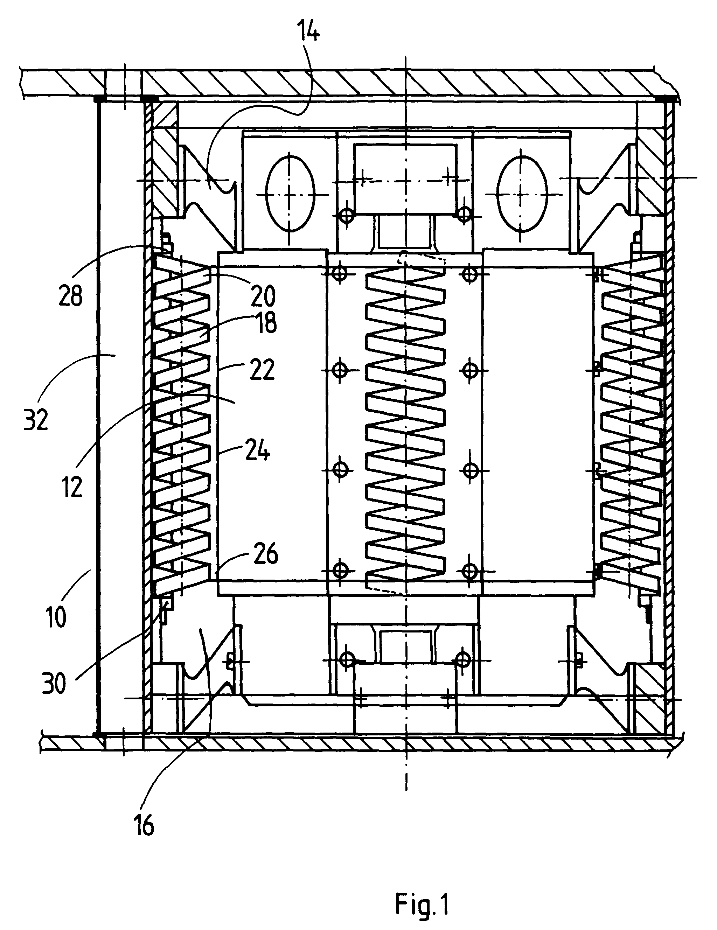

In Fig.1 ist mit 10 ein Gehäuse bezeichnet. In dem Gehäuse 10 ist eine wärmeentwickelnde elektrische oder elektronische Baugruppe 12 über Gummikörper 14 schwingungsgedämpft gelagert. Zwischen der Baugruppe 12 und dem Gehäuse 10 ist ein Mantelraum 16 gebildet. In diesem Mantelraum 16 sind wärmeableitende Mittel in Form von mehreren gewendelten Bändern 18 angeordnet. Die Bänder 18 bestehen aus geflochtenen Litzen aus einem gut wärmeleitenden Material.wie Kupfer. Beispiele für solche Litzen sind beschrieben in einer Firmendruckschrift "Hochflexible Kupferleiter" der NE-Metalldrahtwerk Aurnhammer + Benedict, Obere Stadtmühlgasse 1, 8832 Weissenburg.

Die wendelförmigen Bänder 18 sind an Stellen 20,22,24 und 26 wärmeleitend mit der Baugruppe 12 verbunden. Auf der gegenüberliegenden, äußeren Seite sind die wendelförmigen Bänder 18 an Stellen 28 und 30, hier den Enden der Bänder mit der Innenwandung des Gehäuses 10 verbunden. Die wendelförmigen Bänder 18 liegen auf der Außenseite an der Innenwandung des Gehäuses 10 an. Die Stellen 28 und 30 sind axial gegen die Stellen 20,22,24 und 26 versetzt.

Im Gehäuse 10 sind im Bereich der wendelförmigen Bänder Kühlkanäle 32 gebildet. Durch diese Kühlkanäle 32 wird ein wärmeabführendes Kühlmittel geleitet. Das Kühlmittel kann dabei Luft sein.

Die beschriebene Anordnung gestattet eine Wärmeabfuhr über die gewendelten Bänder. Die Bänder 18 beeinträchtigen aber die schwingungsgedämpfte Aufhängung der Baugruppe in dem Gehäuse 10 nicht.

## Patentansprüche

1. Einrichtung zur Wärmeabfuhr von einer schwingungsgedämpft aufgehängten Baugruppe (12) zu einem weiteren Bauteil (10) enthaltend,
(a) wenigstens ein gewendeltes Band (18), das zumindest teilweise aus einem gut wärmeleitenden Material besteht,
(b) das zwischen einer Mantelfläche der Baugruppe (12) und einer Innenfläche eines die Baugruppe (12) umgebenden Gehäuses (10) die Flächen berührend angeordnet ist und
(c) mit einer der Flächen formschlüssig verbunden ist
wobei
(d) das gewendelte Band (18) aus einer bandförmig geflochtenen Litze aus gut wärmeleitendem Material besteht und
(e) das gewendelte Band (18) einerseits an mindestens zwei axial gegeneinander versetzten Stellen (20, 22, 24, 26) mit einer Mantelfläche der Baugruppe (12) und andererseits an mindestens zwei axial gegeneinander versetzten Stellen (28, 30) mit einer Innenfläche des Gehäuses (10) formschlüssig wärmeableitend verbunden ist.

2. Einrichtung nach Anspruch 1, **dadurch gekennzeichnet**, daß die Stellen (20, 22, 24, 26), an denen das gewendelte Band (18) mit der Baugruppe (12) verbunden ist axial versetzt sind gegen die Stellen (28, 30) an denen das Band (18) mit dem Gehäuse (10) verbunden ist.

3. Einrichtung nach Anspruch 1 oder 2, **dadurch gekennzeichnet, daß** die Baugruppe (12) in dem Gehäuse (10) über von den Bändern (18) unabhängigen Gummikörpern (14) schwingungsgedämpft gelagert ist.

4. Einrichtung nach einem oder mehreren Ansprüche 1 bis 3, **dadurch gekennzeichnet, daß** um die Baugrupee (12) herum mehrere gewendelte, wärmeabführende Bänder (18) vorgesehen sind.

5. Einrichtung nach einem oder mehreren der Ansprüche 1 bis 4, **dadurch gekennzeichnet, daß** in dem Gehäuse (10) im Bereich der Bänder (18) Kühlkanäle (32) gebildet sind.

## Claims

1. Device for heat dissipation from an assembly (12), which is suspended in a way to damp oscillations, to a further component (10), comprising
(a) at least one coiled strip (18), which consists at least partially of a well heat-conducting material,
(b) which is arranged between a peripheral surface of the assembly (12) and an inner surface of the housing (10) which surrounds the assembly (12) touching the surfaces and
(c) is connected positively with one of the surfaces wherein
(d) the coiled strip (18) consists of a strip-shaped stranded wire strand of a well heat-conducting material and
(e) the coiled strip (18) is connected, on one hand, positively, heat dissipating at at least two axial offset positions (20, 22, 24, 26) with a peripheral surface of the assembly (12) and, on the other hand, at at least two axial offset positions (28, 30) with an inner surface of the housing (10).

2. Device as claimed in claim 1, **characterized in that** the positions (20, 22, 24, 26), at which the coiled strip (18) is connected with the assembly (12) are axial offset relative to the positions (28, 30) at which the strip (18) is connected with the housing (10).

3. Device as claimed in claim 1 or 2, **characterized in that** the assembly (12) is supported in the housing (10) in a way to damp oscillations by rubber bodies(14) which are independent of the strips (18).

4. Device as claimed in one or several claims of claim 1 to 3, **characterized in that** a plurality of heat dissipating strips (18) are provided around the assembly (12).

5. Device as claimed in one or several claims of claim 1 to 4, **characterized in that** cooling passages (32) are formed in the housing (10) in the region of the strips (18).

## Revendications

1. Installation destinée à l'évacuation de la chaleur d'un groupe (12) suspendu de façon à amortir les vibrations vers un autre élément (10) comprenant,
(a) au moins un ruban hélicoïdal (18) qui se compose au moins partiellement d'un matériau bon conducteur de chaleur,
(b) qui est disposé, en touchant les surfaces, entre une surface de manteau du groupe (12) et une surface intérieure d'un boîtier (10) entourant le groupe (12) et
(c) qui est relié de toute sa surface à l'une des surfaces,
(d) le ruban hélicoïdal (18) se composant d'un cordon tressé en forme de ruban constitué d'un matériau bon conducteur de chaleur et
(e) le ruban hélicoïdal (18) étant relié de façon à conduire la chaleur sur toute sa surface, d'un côté, à au moins deux endroits (20,22,24,26) décalés axialement l'un par rapport à l'autre à une surface de manteau du groupe (12) et, de l'autre côté, à au moins deux endroits (28,30) décalés axialement l'un par rapport à l'autre à une surface intérieure du boîtier (10).

2. Installation selon la revendication 1, **caractérisée par le fait que** les endroits (20,22,24,26) auxquels le ruban hélicoïdal (18) est relié au groupe (12) sont décalés axialement par rapport aux endroits (28,30) auxquels le ruban (18) est relié au boîtier (10).

3. Installation selon la revendication 1 ou 2, **caractérisée par le fait que** le groupe (12) est logé dans le boîtier (10) de façon à amortir les vibrations par l'intermédiaire de corps en caoutchouc (14) indépendants des rubans (18).

4. Installation selon l'une ou plusieurs des revendications 1 à 3, **caractérisée par le fait que** plusieurs rubans hélicoïdaux (18) évacuateurs de chaleur sont disposés autour du groupe (12).

5. Installation selon l'une ou plusieurs des revendications 1 à 4, **caractérisée par le fait que** des canaux de refroidissement (32) sont formés dans le boîtier (10) dans le domaine des rubans (18).
